# EUROPEAN PATENT SPECIFICATION

(11) **EP 4 321 942 B1**
(45) Date of publication and mention of the grant of the patent: **26.11.2025**
(21) Application number: 22810170.5
(22) Date of filing: 28.03.2022
(51) Int. Cl.: G04G 17/08, G06F 1/16, H01Q 1/27, H01Q 1/36, G04R 60/02

(54) **WEARABLE ELECTRONIC DEVICE**
TRAGBARE ELEKTRONISCHE VORRICHTUNG
DISPOSITIF ÉLECTRONIQUE POUVANT ÊTRE PORTÉ

(30) Priority: 24.05.2021 CN 202110565282
(43) Date of publication of application: 14.02.2024
(73) Proprietor: Huawei Technologies Co., Ltd., Longgang Shenzhen, Guangdong 518129 (CN)
(72) Inventor: YANG, Rongguang, Shenzhen, Guangdong 518129 (CN); ZHONG, Huiting, Shenzhen, Guangdong 518129 (CN); LIU, Bing, Shenzhen, Guangdong 518129 (CN); GAO, Jianming, Shenzhen, Guangdong 518129 (CN); ZHAO, Menglong, Shenzhen, Guangdong 518129 (CN); ZHANG, Bin, Shenzhen, Guangdong 518129 (CN); LI, Huilan, Shenzhen, Guangdong 518129 (CN); ZHANG, Pan, Shenzhen, Guangdong 518129 (CN); GOU, Xiaogang, Shenzhen, Guangdong 518129 (CN)
(74) Representative: Pfenning, Meinig & Partner mbB
(86) International application number: PCT/CN2022/083362
(87) International publication number: WO 2022/247436

(56) References cited:
- EP-A1- 4 350 880
- CN-A- 1 320 722
- CN-A- 105 301 952
- CN-A- 110 324 467
- CN-A- 110 505 325
- CN-A- 111 830 818
- CN-U- 202 262 122
- CN-U- 207 802 040
- CN-U- 208 386 865
- JP-A- 2008 249 500
- JP-A- 2016 507 777
- US-A1- 2015 220 109
- US-A1- 2015 245 513
- US-A1- 2018 262 226
- US-A1- 2020 073 445

## Description

This application claims priority to Chinese Patent Application No. 202110565282.X, filed with the China National Intellectual Property Administration on May 24, 2021 and entitled "WEARABLE ELECTRONIC DEVICE".

### TECHNICAL FIELD

This application relates to the field of electronic devices, and specifically, to a wearable electronic device.

### BACKGROUND

Housings of the wearable electronic devices such as a watch or a band are usually made of plastic materials and metal materials. The plastic material lacks texture, and the metal material has high density and therefore has a heavy weight. Therefore, it is expected to seek a material with good texture and low density to replace the plastic material and metal material. It is found through research that a carbon fiber material has low density (approximately 1.8 grams per cubic centimeter) and high strength, and has good texture because of unique texture in appearance. Therefore, as an alternative material that can be used in the wearable electronic device, the carbon fiber material is more frequently used as a main material for making the housing.

Some wearable electronic devices represented by smartwatches typically have antennas. The antennas of all of these wearable electronic devices are formed by using housings. The antennas may be classified into a Bluetooth antenna, a navigation satellite timing and ranging global position system (Navigation Satellite Timing and Ranging Global Position System, GPS for short) antenna, a Wi-Fi (Wireless Fidelity) antenna, a 4G/5G communication antenna, and the like based on different bands. When the housing of the wearable electronic device is made of the plastic material, metallization processing is performed on a surface of the housing to form the antenna. When the housing of the wearable electronic device is made of the metal material, the housing is electrically connected to a circuit board assembly to form the antenna.

US 2018/262226 A1 and US2020/073445 A1 disclose wearable electronic devices with housings comprising carbon fiber material.

However, when the housing of the wearable electronic device is made of the carbon fiber material, in addition to the carbon fiber material, the housing may further include plastic prepreg, or may include a specific proportion of glass fibers. The carbon fiber material is a conductor, while the plastic prepreg and the glass fiber are non-conductors. The housing made in this way is a discontinuous conductor structure, and cannot be well conducted as a part of the antenna, but instead forms a shielding housing that affects radiation performance of the antenna.

### SUMMARY

In view of this, a wearable electronic device is provided. In the wearable electronic device, a housing including a carbon fiber material can be used as a part of an antenna, to improve antenna performance of the wearable electronic device including the housing made of the carbon fiber material.

Therefore, the following technical solutions are used in this application.

Solution 1 of this application provides a wearable electronic device. The wearable electronic device includes a housing and a circuit board assembly. The circuit board assembly is located inside the housing, and is fastened relative to the housing. The housing includes a carbon fiber material, the housing has an inner surface, the housing includes a conductive layer disposed on the inner surface, the conductive layer electrically connects the carbon fiber material scattered in the housing, and the housing is electrically connected to the circuit board assembly by using the conductive layer.

In the technical solution, the carbon fiber material scattered in the housing is electrically connected by using the conductive layer disposed on the inner surface of the housing, so that the housing is integrally formed as a conductor, and the housing is further electrically connected to the circuit board assembly by using the conductive layer. Therefore, the housing including the carbon fiber material is used as a part of an antenna, to improve antenna performance of the wearable electronic device including the housing made of the carbon fiber material. The solution is easy to implement, and is conducive to large-scale industrial production.

Based on the wearable electronic device according to solution 1 of this application, solution 2 of this application provides the following wearable electronic device: The wearable electronic device further includes a metal inner container, the metal inner container is located inside the housing, and the housing is electrically connected to the circuit board assembly by using the conductive layer and the metal inner container.

In the technical solution, the metal inner container can improve dustproof and waterproof performance of the wearable electronic device, and improve structural strength, and the metal inner container can be used as a part of the antenna, to improve the antenna performance of the wearable electronic device.

Based on the wearable electronic device according to solution 2 of this application, solution 3 of this application provides the following wearable electronic device: The wearable electronic device further includes an elastic component, the elastic component is located between the housing and the metal inner container, and the housing is electrically connected to the metal inner container by using the elastic component.

In the technical solution, when the wearable electronic device has the metal inner container, the housing and the metal inner container may be stably and reliably electrically connected by using the elastic component, to eliminate a possibility of a virtual connection between the housing and the metal inner container.

Based on the wearable electronic device according to solution 3 of this application, solution 4 of this application provides the following wearable electronic device: The elastic component has a body and a spring plate, the body is fastened to one of the housing and the metal inner container, one end of the spring plate is connected to the body, and the other end of the spring plate is tilted relative to the body, to press against the other one of the housing and the metal inner container.

In the technical solution, an elastic component solution that has a simple structure and that can effectively provide elastic force is provided. In addition, the elastic component occupies small space and is easy to assemble.

Based on the wearable electronic device according to any one of solutions 2 to 4 of this application, solution 5 of this application provides the following wearable electronic device: The wearable electronic device further includes a conductive adhesive or a conductive fabric, the conductive adhesive or the conductive fabric is located between the housing and the metal inner container, and the housing is electrically connected to the metal inner container by using the conductive adhesive or the conductive fabric.

In the technical solution, different additional conductive means may be selected based on a requirement to reliably electrically connect the housing and the metal inner container, to improve an antenna gain of the wearable electronic device.

Based on the wearable electronic device according to any one of solutions 2 to 5 of this application, solution 6 of this application provides the following wearable electronic device: A part of the metal inner container is exposed from the housing.

In the technical solution, an antenna gain of the wearable electronic device can be improved.

Based on the wearable electronic device according to solution 1 of this application, solution 7 of this application provides the following wearable electronic device: The wearable electronic device further includes a plastic inner container, the plastic inner container is located inside the housing, a conductive part is disposed in the plastic inner container, and the housing is electrically connected to the circuit board assembly by using the conductive part and the conductive layer.

In the technical solution, the plastic inner container can improve dustproof and waterproof performance of the wearable electronic device, improve structural strength, and strengthen, when a large amount of mechanical processing can be saved, a lightweight feature brought by the housing mainly made of a carbon fiber. The plastic inner container can further provide antenna clearance, to improve antenna performance of the housing. In addition, a stable and reliable electrical connection between the housing and the circuit board assembly is ensured by using the conductive layer on the housing and the conductive part in the plastic inner container.

Based on the wearable electronic device according to solution 7 of this application, solution 8 of this application provides the following wearable electronic device: The conductive part includes a metal trace, and the metal trace is formed by using a laser direct structuring technology or through laser activating plating.

In the technical solution, different solutions for forming the conductive part in the plastic inner container are provided, to help use corresponding means for different cases. Further, in a solution in which the metal trace is formed in the plastic inner container by using the laser direct structuring technology or through laser activating plating, the formed metal trace basically does not occupy extra space; and the metal trace is firmly connected to the plastic inner container, and a possibility that a breakpoint occurs in the metal trace is basically excluded.

Based on the wearable electronic device according to solution 7 or 8 of this application, solution 9 of this application provides the following wearable electronic device: A through hole is formed in the plastic inner container, the through hole penetrates through the plastic inner container from a side on which the housing is located to a side on which the circuit board assembly is located, and the conductive part extends through the through hole.

In the solution, the conductive part is formed without greatly changing a structure of the plastic inner container. Therefore, a plastic inner container that can be used in the wearable electronic device in this application can be obtained by performing simple processing on the formed plastic inner container, to reduce mold costs of developing and manufacturing the plastic inner container in this application.

Based on the wearable electronic device according to any one of solutions 7 to 9 of this application, solution 10 of this application provides the following wearable electronic device:

The wearable electronic device further includes a conductive adhesive, the conductive adhesive is located between the plastic inner container and the circuit board assembly, and the conductive part is electrically connected to the circuit board assembly by using the conductive adhesive;
the wearable electronic device further includes a conductive fabric, the conductive fabric is located between the plastic inner container and the circuit board assembly, and the conductive part is electrically connected to the circuit board assembly by using the conductive fabric; or
the wearable electronic device further includes an elastic component, the elastic component is located between the plastic inner container and the circuit board assembly, and the conductive part is electrically connected to the circuit board assembly by using the elastic component.

In the technical solution, when the wearable electronic device has the plastic inner container, different conductive means may be selected based on a requirement to stably and effectively electrically connect the plastic inner container and the circuit board assembly, to improve an antenna gain of the wearable electronic device.

Based on the wearable electronic device according to solution 10 of this application, solution 11 of this application provides the following wearable electronic device: The elastic component has a body and a spring plate, the body is fastened to one of the plastic inner container and the circuit board assembly, one end of the spring plate is connected to the body, and the other end of the spring plate is tilted relative to the body, to press against the other one of the plastic inner container and the circuit board assembly.

In the technical solution, an elastic component solution that has a simple structure and that can effectively provide elastic force is provided. In addition, the elastic component occupies small space and is easy to assemble.

Based on the wearable electronic device according to solution 1 of this application, solution 12 of this application provides the following wearable electronic device: The wearable electronic device further includes a plastic inner container, the plastic inner container is located inside the housing, the housing includes a protruding part, the protruding part passes through the plastic inner container and extends to the circuit board assembly, the conductive layer is further disposed on the protruding part, and the housing is electrically connected to the circuit board assembly by using the conductive layer on the protruding part.

In the technical solution, when the wearable electronic device has the plastic inner container, a technical means for directly and effectively electrically connecting the housing and the circuit board assembly is provided, to improve an antenna gain of the wearable electronic device.

Based on the wearable electronic device according to any one of solutions 2 to 12 of this application, solution 13 of this application provides the following wearable electronic device:

The housing and the inner container are separately made, and the housing and the inner container are fastened to each other; or
the inner container and the housing are integrally formed.

In the technical solution, a method for manufacturing the inner container and the housing may be selected based on a requirement, to implement application to different types of wearable electronic devices.

Based on the wearable electronic device according to any one of solutions 1 to 13 of this application, solution 14 of this application provides the following wearable electronic device: The housing includes a ring-shaped substrate, the substrate includes the carbon fiber material, the inner surface is an inner circumferential surface of the substrate, and the conductive layer continuously extends on the entire inner circumferential surface in a circumferential direction of the substrate.

In the technical solution, the housing of the wearable electronic device can be used as an entire conductor to form a part of the antenna, to ensure that the entire housing is used as a part of the antenna of the wearable electronic device.

Based on the wearable electronic device according to any one of solutions 1 to 13 of this application, solution 15 of this application provides the following wearable electronic device: The housing includes a substrate and a filling block, a slit is formed in the substrate, the slit is filled with the filling block, so that the substrate and the filling block form a ring shape together, and the inner surface is an inner circumferential surface of the substrate and an inner circumferential surface of the filling block.

In the technical solution, the housing may be segmented to be used as antennas with different bands. This can improve receiving and sending efficiency of an antenna signal and improve antenna performance.

Based on the wearable electronic device according to solution 15 of this application, solution 16 of this application provides the following wearable electronic device: The carbon fiber material is included in the substrate, the filling block is made of plastic, and the conductive layer is located only on the inner circumferential surface of the substrate.

In the technical solution, the filling block does not have a conductive function, and the conductive layer is located only on the inner circumferential surface of the substrate, so that different segments of the housing correspond to antenna signals with different receiving and sending efficiency, to improve antenna performance. In addition, the slit formed in the substrate is filled with the filling block, so that structural strength reduction caused due to formation of the slit in the substrate can be compensated.

Based on the wearable electronic device according to any one of solutions 1 to 16 of this application, solution 17 of this application provides the following wearable electronic device:

The conductive layer is a non-transparent film formed through electroplating, and the conductive layer includes at least one of copper, nickel, chromium, zinc, iron, gold, or silver;
the conductive layer has a multi-layer structure, and the multi-layer structure includes a copper layer and a gold layer, the multi-layer structure includes a titanium layer and an aluminum layer, or the multi-layer structure includes a nickel layer and a chromium layer;
the conductive layer is a transparent film formed through electroplating, and the conductive layer includes indium tin oxide; or
the conductive layer is a ceramic conductive film, and the conductive layer includes at least one of titanium carbide, titanium nitride, or titanium boride.

In the technical solution, different materials may be selected based on a requirement to make the conductive layer, to expand an application field of the wearable electronic device.

Based on the wearable electronic device according to solution 1 of this application, solution 18 of this application provides the following wearable electronic device:

The wearable electronic device further includes a conductive adhesive, the conductive adhesive is located between the housing and the circuit board assembly, and the housing is electrically connected to the circuit board assembly by using the conductive adhesive and the conductive layer;
the wearable electronic device further includes a conductive fabric, the conductive fabric is located between the housing and the circuit board assembly, and the housing is electrically connected to the circuit board assembly by using the conductive fabric and the conductive layer;
the wearable electronic device further includes an elastic component, the elastic component is located between the housing and the circuit board assembly, and the housing is electrically connected to the circuit board assembly by using the elastic component and the conductive layer; or
the housing includes a protruding part extending out to the circuit board assembly, the conductive layer is further disposed on the protruding part, and the housing is electrically connected to the circuit board assembly by using the conductive layer on the protruding part.

In the technical solution, when the wearable electronic device has no inner container, different conductive means may be selected based on a requirement to effectively electrically connect the housing and the circuit board assembly, to improve an antenna gain of the wearable electronic device.

Based on the wearable electronic device according to solution 18 of this application, solution 19 of this application provides the following wearable electronic device: The elastic component has a body and a spring plate, the body is fastened to one of the housing and the circuit board assembly, one end of the spring plate is connected to the body, and the other end of the spring plate is tilted relative to the body, to press against the other one of the housing and the circuit board assembly.

In the technical solution, an elastic component solution that has a simple structure and that can effectively provide elastic force is provided.

Based on the wearable electronic device according to any one of solutions 1 to 19 of this application, solution 20 of this application provides the following wearable electronic device: The wearable electronic device further includes a screen assembly, the screen assembly is fastened to the housing, the screen assembly is electrically connected to the circuit board assembly, and the screen assembly includes a display part exposed after the wearable electronic device is assembled.

In the technical solution, the wearable electronic device has the screen assembly, and a user may interact with the wearable electronic device by using the screen assembly.

Based on the wearable electronic device according to any one of solutions 1 to 20 of this application, solution 21 of this application provides the following wearable electronic device: The wearable electronic device is a watch or a band.

In the technical solution, application of the wearable electronic device is expanded.

These aspects and other aspects of this application are more concise and more comprehensive in descriptions of the following (a plurality of) embodiments.

### BRIEF DESCRIPTION OF DRAWINGS

The accompanying drawings that are included in this specification and that form a part of this specification and this specification jointly show example embodiments, features, and aspects of this application, and are intended to explain principles of this application.
FIG. 1A is a schematic diagram of an exploded structure of a wearable electronic device according to a first embodiment of this application;
FIG. 1B is a schematic sectional view of a partial structure of the wearable electronic device in FIG. 1A;
FIG. 2A is a schematic diagram of an exploded structure of a wearable electronic device according to a second embodiment of this application;
FIG. 2B is a schematic sectional view of a partial structure of the wearable electronic device in FIG. 2A;
FIG. 2C is a schematic diagram of a structure of a first elastic component of the wearable electronic device in FIG. 2A;
FIG. 3A is a schematic diagram of an exploded structure of a wearable electronic device according to a third embodiment of this application, where a screen assembly is omitted;
FIG. 3B is a schematic sectional view of a partial structure of the wearable electronic device in FIG. 3A;
FIG. 3C is a schematic diagram of a three-dimensional structure of a housing of the wearable electronic device in FIG. 3A;
FIG. 3D is a schematic diagram of a structure of a second elastic component of the wearable electronic device in FIG. 3A;
FIG. 4 is a schematic sectional view of a partial structure of a wearable electronic device according to a fourth embodiment of this application;
FIG. 5A is a schematic diagram of a partial exploded structure of a wearable electronic device according to a fifth embodiment of this application;
FIG. 5B is a schematic diagram of a partial structure of the wearable electronic device in FIG. 5A; and
FIG. 6 is a schematic diagram of a housing of a wearable electronic device according to a sixth embodiment of this application.

Description of reference numerals:
1: Housing; 11: Housing substrate; 11i: Inner circumferential surface; 11g: Gap; 12: Housing extension part; 13: Conductive layer; 14: Filling block; 15: Protruding part;
2: Metal inner container; 21: Inner container substrate; 21c: First mounting concave part; 22: Inner container extension part; 23: Conductive adhesive; 24: First elastic component; 241: First body; 242: First spring plate;
2': Plastic inner container; 2'h: Through hole; 21': Inner container substrate; 211': First part; 212': Second part; 213': Reinforcing block; 22': Inner container extension part; 23': Conductive part;
3: Circuit board assembly; 3c: Second mounting concave part; 31: Second elastic component; 311: Second body; 312: Second spring plate;
4: Rear housing;
5: Screen assembly; 51: Display part; and
A: Axial direction.

### DESCRIPTION OF EMBODIMENTS

The following describes various example embodiments, features, and aspects of this application in detail with reference to the accompanying drawings. Same reference numerals in the accompanying drawings indicate elements that have same or similar functions. Although various aspects of embodiments are shown in the accompanying drawings, the accompanying drawings are not necessarily drawn to scale unless otherwise specified.

The specific term "example" herein means "used as an example, embodiment, or illustration". Any embodiment described as an "example" is not necessarily explained as being superior or better than other embodiments.

In addition, to better describe this application, numerous specific details are provided in the following specific embodiments. A person skilled in the art should understand that this application can also be implemented without some specific details. In some instances, methods, means, and elements that are well-known to a person skilled in the art are not described in detail, to highlight the subject matter of this application.

It should be noted that a "ring shape" described in this application includes but is not limited to various ring shapes such as a circular ring shape, a square ring shape, and an elliptic ring shape.

The following describes structures of wearable electronic devices according to embodiments of this application with reference to the accompanying drawings of this specification.

(Structure of a wearable electronic device according to a first embodiment of this application)

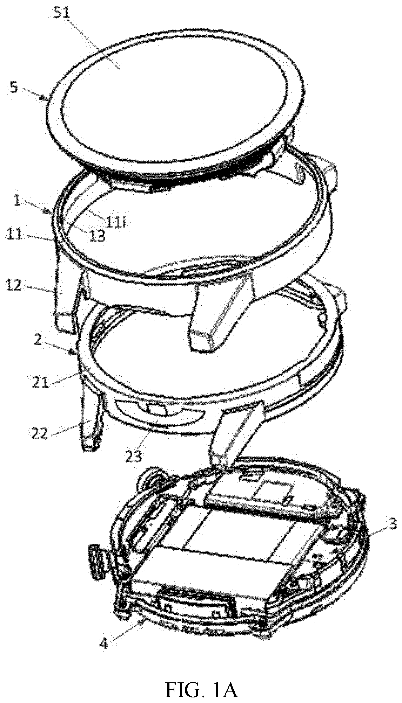

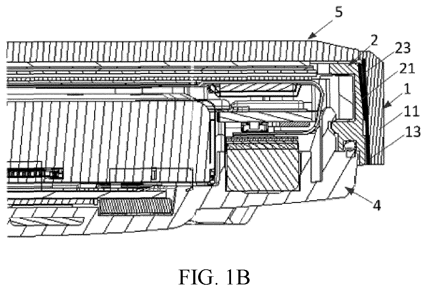

As shown in FIG. 1A and FIG. 1B, the wearable electronic device according to the first embodiment of this application includes a housing 1, a metal inner container 2, a circuit board assembly 3, a rear housing 4, and a screen assembly 5 that are assembled together. The housing 1, the rear housing 4, and the screen assembly 5 form mounting space through enclosing, and the metal inner container 2 and the circuit board assembly 3 are located in the mounting space.

Specifically, in this embodiment, as shown in FIG. 1A, the housing 1 includes a ring-shaped housing substrate 11 and a housing extension part 12 integrally formed with the housing substrate 11. Two pairs of housing extension parts 12 respectively extend from the housing substrate 11 toward two sides, and are configured to cover an inner container extension part 22 of the metal inner container 2. The housing substrate 11 has an inner circumferential surface 11i that continuously extends in a circumferential direction of the housing substrate 11. The inner circumferential surface 11i of the housing substrate 11 is used as an inner surface of the housing 1. As shown in FIG. 1B, after the wearable electronic device is assembled, the inner circumferential surface 11i of the housing substrate 11 faces the mounting space, and is completely covered, and a user cannot see the inner circumferential surface 11i.

The housing 1 is mainly made of a carbon fiber material. To enable the housing 1 to form a part of an antenna, as shown in FIG. 1A and FIG. 1B, the housing 1 includes a conductive layer 13 disposed on the inner circumferential surface 11i of the housing substrate 11, and the conductive layer 13 electrically connects the carbon fiber material scattered in the housing 1, to enhance conductivity of the entire housing 1. In this embodiment, the conductive layer 13 may include a metal component. Specifically, the conductive layer 13 may be a non-transparent film formed through electroplating. In this case, the conductive layer 13 optionally includes at least one of copper, nickel, chromium, zinc, iron, gold, or silver. The conductive layer 13 may have a multi-layer structure. The multi-layer structure may be a multi-layer structure in which a material layer and another material layer are alternately stacked, or may be a multi-layer structure obtained by coating a material layer with another material layer. Specifically, the multi-layer structure may include a copper layer and a gold layer, a titanium layer and an aluminum layer, or a nickel layer and a chromium layer. Alternatively, the conductive layer 13 may be a transparent film formed through electroplating. In this case, the conductive layer 13 optionally includes indium tin oxide. In an optional solution, the conductive layer 13 may be a ceramic conductive film like titanium carbide, titanium nitride, or titanium boride. Regardless of a material used to make the conductive layer 13, in this embodiment, the conductive layer 13 continuously extends in the circumferential direction on the entire inner circumferential surface 11i of the housing substrate 11, and covers the entire inner circumferential surface 11i. In addition to a case in which the conductive layer 13 electrically connects the carbon fiber scattered in the housing 1 to form a conductor, there is a case in which the housing 1 can be electrically connected to the metal inner container 2 by using the conductive layer 13.

Further, in this embodiment, as shown in FIG. 1A and FIG. 1B, the metal inner container 2 is made of or mainly made of a metal material. The metal inner container 2 is located between the housing 1 and the circuit board assembly 3, and the metal inner container 2 is not only electrically connected to the housing 1, but also electrically connected to the circuit board assembly 3. The metal inner container 2 includes a ring-shaped inner container substrate 21 and the inner container extension part 22 integrally formed with the inner container substrate 21. After the wearable electronic device is mounted, the inner container substrate 21 is located on a radial inner side of the housing substrate 11, and the inner container extension part 22 is inserted into the housing extension part 12. The metal inner container 2 is mainly used to improve dustproof and waterproof performance and structural strength of the wearable electronic device.

As shown in FIG. 1A and FIG. 1B, to fasten and electrically connect the housing 1 and the metal inner container 2, the wearable electronic device includes a conductive adhesive 23. The conductive adhesive 23 is located between the inner circumferential surface 11i of the housing 1 and an outer circumferential surface of the metal inner container 2, and the conductive adhesive 23 is in contact with the conductive layer 13 on the inner circumferential surface 11i of the housing 1, so that the housing 1 and the metal inner container 2 are fastened together by using the conductive adhesive 23, and are electrically connected by using the conductive adhesive 23. A shape and an arrangement of the conductive adhesive 23 are not limited in this application, provided that the conductive adhesive 23 can implement the foregoing functions. Specifically, a conductive adhesive 23 that is disposed in the metal inner container 2 and whose shape is approximately an arc shape is shown in FIG. 1A. However, this is not limited thereto. The shape of the conductive adhesive 23 may be set to another shape based on a requirement, and may be disposed on different parts of the metal inner container 2. In addition, there is no limitation on a base material and a conductive component of the conductive adhesive 23 in this application, provided that the conductive adhesive 23 can implement the foregoing functions. Specifically, different substrates may be selected based on different curing conditions. The substrate may include various types of plastic, dispersants, additives, and the like. The conductive component of the conductive adhesive 23 may be a conductive material like silver powder, gold powder, copper powder, aluminum powder, zinc powder, nickel powder, carbon powder, or graphite. In addition, the conductive adhesive 23 may be in a form of cream, paste, or conductive adhesive tape. In an optional solution, the conductive adhesive 23 may be replaced with a conductive fabric. The conductive fabric is located between the housing 1 and the metal inner container 2, and the housing 1 and the metal inner container 2 are electrically connected when being fastened together by using the conductive fabric. In addition, the metal inner container 2 may be electrically connected to a corresponding conductive part (for example, a trace) of the circuit board assembly 3 by using a connection column or the like.

Further, in this embodiment, as shown in FIG. 1A, the circuit board assembly 3 and the rear housing 4 are integrated together, and the circuit board assembly 3 is located in the rear housing 4. The circuit board assembly 3 and the rear housing 4 are fastened to the housing 1 from a bottom in FIG. 1B. Specifically, the housing 1 and the rear housing 4 may be connected through clamping or by using a connector like a screw.

Further, in this embodiment, as shown in FIG. 1A, the screen assembly 5 includes a display part 51. The display part 51 displays information to the user after the wearable electronic device is assembled. The display part 51 may further have a function of inputting information, so that the user can interact with the wearable electronic device by using the display part 51. The screen assembly 5 is fastened to the housing 1 from a top in FIG. 1B. Specifically, the housing 1 and the screen assembly 5 may be connected through clamping or bonding, or by using a connector like a screw.

In the technical solution, the conductive layer 13 disposed on the inner surface of the housing 1 enables the housing 1 including the carbon fiber to be integrally formed as a conductor. Further, the metal inner container 2 and the housing 1 are bonded together by using the conductive adhesive 23 or the conductive fabric. The conductive adhesive 23 and the conductive fabric enable the housing 1 on which the conductive layer 13 is disposed and the metal inner container 2 to be electrically connected. The metal inner container 2 is also electrically connected to the circuit board assembly 3. In this way, the housing 1 becomes a part of the antenna of the wearable electronic device, and an antenna gain of the wearable electronic device is increased.

The following describes a structure of a wearable electronic device according to a second embodiment of this application.

### (Structure of the wearable electronic device according to the second embodiment of this application)

The structure of the wearable electronic device according to the second embodiment of this application is basically the same as the structure of the wearable electronic device according to the first embodiment of this application. The following mainly describes a difference between the two wearable electronic devices.

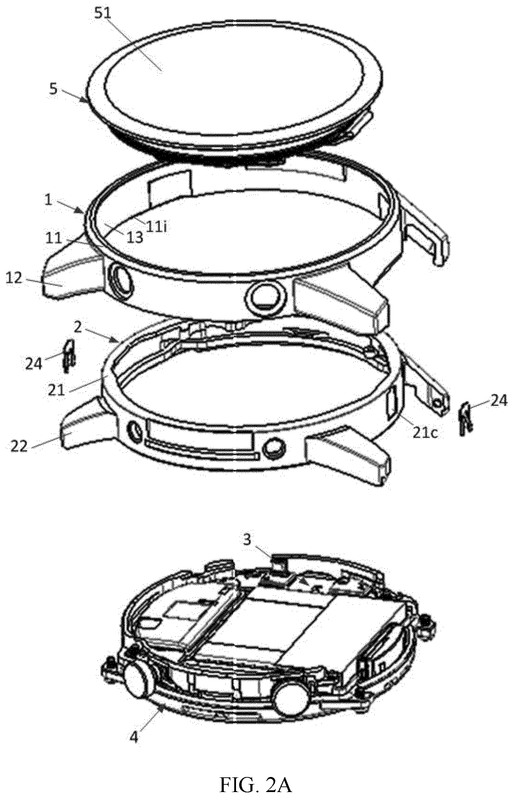

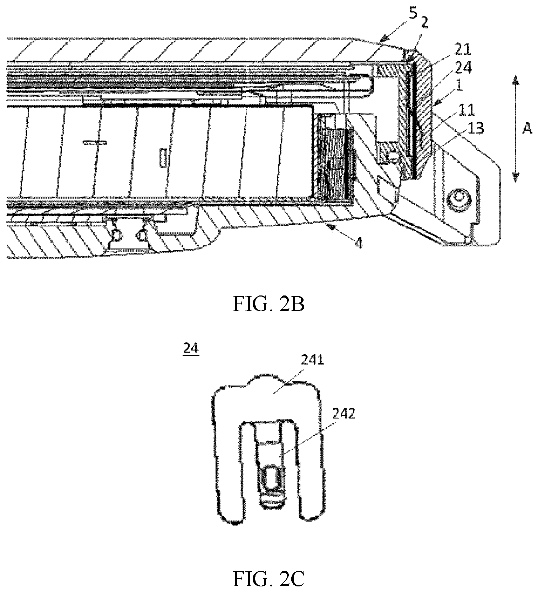

In the description of the first embodiment, the conductive adhesive 23 and the conductive fabric are used to fasten and electrically connect the housing 1 and the metal inner container 2, to ensure reliable conduction between the housing 1 and the metal inner container 2 in various cases such as long-term use or body fluid impregnation. In this embodiment, to further ensure conduction between the housing 1 and the metal inner container 2, as shown in FIG. 2A and FIG. 2B, the wearable electronic device further includes a first elastic component 24. The first elastic component 24 is located between the housing 1 and the metal inner container 2. After the wearable electronic device shown in FIG. 2B is mounted, the first elastic component 24 is in a compressed state, and always applies elastic force to the housing 1 and the metal inner container 2, to further ensure that a stable and reliable electrical connection is formed between the housing 1 and the metal inner container 2 by using the first elastic component.

In this embodiment, as shown in FIG. 2A to FIG. 2C, the first elastic component 24 is formed in a shape of a trident. Specifically, the first elastic component 24 has a first body 241 and a first spring plate 242. The first body 241 has a shape of a bident, and the first body 241 is formed in a sheet shape. A first mounting concave part 21c in which the first body 241 can be accommodated and mounted is formed on an outer circumferential surface of the metal inner container 2. The first body 241 is located in the first mounting concave part 21c, and may be fastened to the metal inner container 2 in an assembly manner like spot welding, bonding, or buckling. One end of the first spring plate 242 is connected to the first body 241, and the first spring plate 242 is located between two prongs of the bident of the first body 241, and obliquely extends toward the housing 1, so that the other end of the first spring plate 242 is tilted relative to the first body 241, to press against a conductive layer 13 on an inner circumferential surface 11i of the housing 1. In other words, the first body 241 is approximately in a U-shaped shape, and the first spring plate 242 is located between two legs of the U-shaped shape, extends from a bottom of the U-shaped shape, and is tilted relative to the first body 241. The entire first elastic component 24 is formed in an approximately W-shaped shape, or an M-shaped shape visible to a user, as shown in FIG. 2C. In an optional solution, the first elastic component 24 may include at least two first spring plates. In this way, by using the first elastic component 24 of the foregoing structure, the housing 1 can be stably electrically connected to the metal inner container 2 by using the conductive layer 13 and the first elastic component 24. In addition, the first elastic component 24 is easy to assemble, occupies small space, has a simple structure, and facilitates batch manufacturing. Further, in another optional solution, a conductive elastic component of another shape, for example, a cylindrical spiral spring or a conical spiral spring, or a conductive elastic component formed by using elasticity of a material may be selected to replace the first elastic component 24. In other words, there is no special limitation on a structure and a material of the elastic component in this application.

In addition, to fit with the first elastic component 24, more types of bonding agents may be selected between the housing 1 and the metal inner container 2. The bonding agents may be various conductive adhesives described in the first embodiment, or may be various structural adhesives, including an adhesive of a silicone base material, an adhesive of an epoxy base material, an adhesive of a hot melt adhesive series, and a two-liquid mixed hardening adhesive of two or more composite components.

In addition, in an optional solution, in an axial direction A of the housing 1, a thickness (or referred to as a height) of the housing 1 is approximately the same as a thickness (or referred to as a height) of the metal inner container 2; or a thickness of the housing 1 is slightly less than a thickness of the metal inner container 2, so that a part (for example, a part with an axial thickness of 0.3 mm) of the metal inner container 2 is exposed from the housing 1 after the wearable electronic device is assembled. In this way, an antenna gain of the wearable electronic device can be improved.

In the solution, compared with the first embodiment, disposing the first elastic component 24 can help improve the electrical connection between the housing 1 and the metal inner container 2.

The following describes a structure of a wearable electronic device according to a third embodiment of this application.

### (Structure of the wearable electronic device according to the third embodiment of this application)

The structure of the wearable electronic device according to the third embodiment of this application is basically the same as the structure of the wearable electronic device according to the first embodiment of this application and the structure of the wearable electronic device according to the second embodiment of this application. The following mainly describes a difference between the two wearable electronic devices.

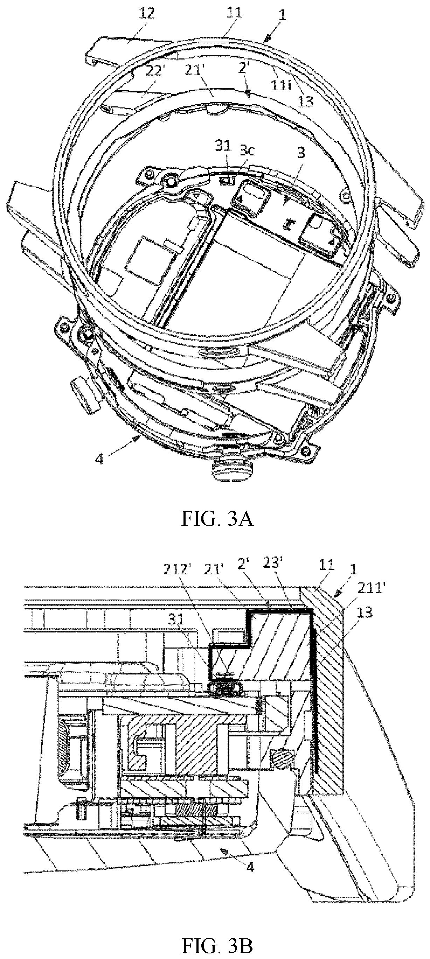

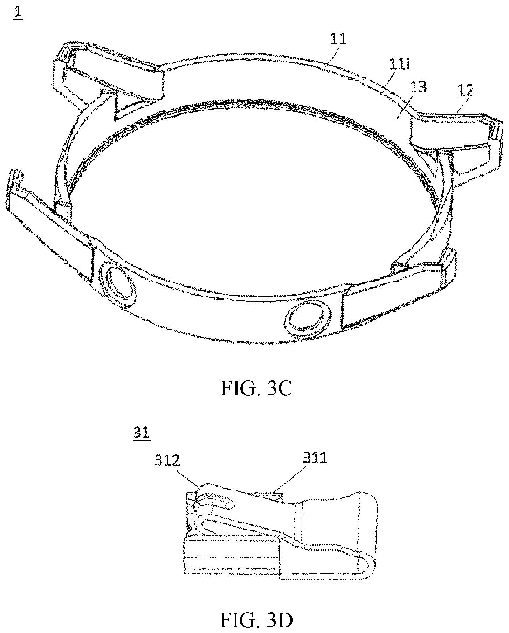

In the first embodiment and the second embodiment, the metal inner container 2 is mainly used to improve dustproof and waterproof performance and structural strength of the wearable electronic device. However, the metal inner container 2 has a very high requirement on a processing amount of mechanical processing. Therefore, costs of the entire wearable electronic device are increased, and the metal inner container 2 further weakens a lightweight feature brought by the housing 1 mainly made of a carbon fiber. Based on the foregoing case, in this embodiment, as shown in FIG. 3A and FIG. 3B, the wearable electronic device includes a plastic inner container 2' to replace the metal inner container 2. The plastic inner container 2' is made of a non-conductive plastic material. The plastic material may be epoxy plastic, polyimide, phenolic plastic, or the like. The plastic inner container 2' may be processed and formed through injection molding. In this way, a shape of the plastic inner container 2' can be formed in a mold, to save a large amount of mechanical processing. In addition, the plastic inner container 2' can further strengthen the lightweight feature brought by the housing 1 mainly made of a carbon fiber. In addition, in this embodiment, as shown in FIG. 3C, a structure of the housing 1 is basically the same as the structure of the housing 1 in the first embodiment and the second embodiment. Therefore, use of the plastic inner container 2' does not cause a significant change to the structure of the housing 1, and the plastic inner container 2' can also improve the dustproof and waterproof performance of the wearable electronic device.

Further, as shown in FIG. 3B, the plastic inner container 2' is located inside the housing 1, the plastic inner container 2' is fastened relative to the housing 1, and the housing 1 and a circuit board assembly 3 are separated by the plastic inner container 2'. In this way, because the plastic inner container 2' separates the housing 1 from the circuit board assembly 3 by a specific distance, clearance of an antenna is formed, and performance of the antenna can be improved. Similar to the structure of the metal inner container 2, as shown in FIG. 3A, the plastic inner container 2' includes a ring-shaped inner container substrate 21' and an inner container extension part 22' integrally formed with the inner container substrate 21'. Two groups of inner container extension parts 22' extend from the inner container substrate 21' toward two sides.

Further, to ensure an electrical connection between the housing 1 and the circuit board assembly 3, the following solution is used in this embodiment. As shown in FIG. 3B, the plastic inner container 2' has a first part 211' and a second part 212'. The first part 211' faces an inner circumferential surface 11i of a substrate of the housing 1, and the second part 212' faces the circuit board assembly 3. A conductive part 23' is disposed in the plastic inner container 2', and the conductive part 23' extends from the first part 211' to the second part 212' along an outer surface of the plastic inner container 2'. A conductive part 23' on the first part 211' is always in contact with a conductive layer 13, and a conductive part 23' on the second part 212' is in contact with a second elastic component 31 disposed on the circuit board assembly 3. In this way, the housing 1 is well electrically connected to the circuit board assembly 3 by using the conductive layer 13, the conductive part 23', and the second elastic component 31, to ensure antenna performance. In this embodiment, a metal trace used as the conductive part 23' may be disposed in the plastic inner container 2' by using a laser direct structuring (Laser Direct Structuring, LDS for short) technology or through laser activating plating (Laser Activating Plating, LAP for short).

In addition, as shown in FIG. 3D, the second elastic component 31 has a second body 311 and a second spring plate 312. The second spring plate 312 is formed by performing foldback from one end of the second body 311, and the second spring plate 312 is bent for a plurality of times to be tilted relative to the second body 311. More specifically, as shown in FIG. 3A, a second mounting concave part 3c for accommodating and mounting the second elastic component 31 is disposed on the circuit board assembly 3. One end of the second spring plate 312 is connected to the second body 311, and the other end of the second spring plate 312 is tilted relative to the second body 311, to press against the conductive part 23' in the plastic inner container 2'. In this way, conductive performance between the conductive part 23' disposed in the plastic inner container 2' and the circuit board assembly 3 can be improved by using the second elastic component 31. In addition to using the second elastic component 31, in an optional solution, a conductive adhesive or a conductive fabric may be disposed between the plastic inner container 2' and the circuit board assembly 3 to improve the conductive performance between the conductive part 23' disposed in the plastic inner container 2' and the circuit board assembly 3.

In this embodiment, the housing 1 and the plastic inner container 2' may be manufactured and assembled in a plurality of manners. In a first optional manner, the housing 1 and the plastic inner container 2' are separately processed. The conductive layer 13 is disposed on an inner surface of the housing 1. The plastic inner container 2' is formed through injection molding, and the conductive part 23' is disposed at a part that is of the plastic inner container 2' and that is opposite to the conductive layer 13. Then, the housing 1 and the plastic inner container 2' are bonded and fastened together by using a bonding agent. In a second optional manner, the plastic inner container 2' is processed by using an injection molding process, and then is put into a mold for multi-layer carbon fiber stacking, and a composite structure is integrally formed through hot pressing and curing. Polycarbonate (Polycarbonate, PC for short) and polyamide (Polyamide, PA for short) series plastic with a high softening point may be selected as a material of the plastic inner container 2'. The softening point of the plastic is 130°C-150°C, and the softening point and strength can be improved by adding a glass fiber. For example, after PA66 is reinforced by adding a glass fiber, a thermal deformation temperature of the PA66 can reach 250°C or higher. In this way, it is ensured that the plastic inner container is not softened or deformed in a subsequent carbon fiber forming process. In addition, to enhance bonding force between a plastic material and a carbon fiber material, a surface of the plastic inner container 2' may be coated with an activator in advance. In addition, to ensure that the plastic inner container 2' is not deformed in a process of hot pressing an outer layer of carbon fiber, a corresponding internal support design may be made for a hot pressing mold. The conductive part 23' in the plastic inner container 2' is also a metal coating formed by using the foregoing technology. After wrapping is performed by using a carbon fiber material, the metal coating and the carbon fiber material are seamlessly connected and conducted, to achieve ideal conduction effect. In a third optional manner, some protruding parts (for example, ribs) are designed at a conduction part that is of the housing 1 and that corresponds to the circuit board assembly 3. A carbon fiber material is first hot pressed in a mold to form the housing 1, and then a surface that includes the protruding part and that is on an inner side of the housing 1 is coated to form a part of the antenna. Then, an injection molding mold is placed, and then the plastic inner container 2' is injection molded. The plastic inner container 2' performs a filling and reinforcing function for the housing 1. The protruding part on the housing 1 and the circuit board assembly 3 are conducted through contact pressing or by using a spring plate, a conductive fabric, a conductive soft adhesive, or the like, so that good antenna effect can also be achieved. Similar to the housing 1 and the plastic inner container 2' that may be manufactured and assembled in a plurality of manners, the housing 1 and the metal inner container 2 may also be manufactured and assembled in a similar manner.

In addition, in an optional solution, the housing 1 includes a protruding part (for example, a rib or a reinforcing rib). The protruding part passes through the plastic inner container 2' and extends to the circuit board assembly 3, the conductive layer 13 covers the entire protruding part, and the circuit board assembly 3 is electrically connected to the housing 1 by using the protruding part.

The following describes a structure of a wearable electronic device according to a fourth embodiment of this application.

### (Structure of the wearable electronic device according to the fourth embodiment of this application)

The structure of the wearable electronic device according to the fourth embodiment of this application is basically the same as the structure of the wearable electronic device according to the third embodiment of this application. The following mainly describes a difference between the two wearable electronic devices.

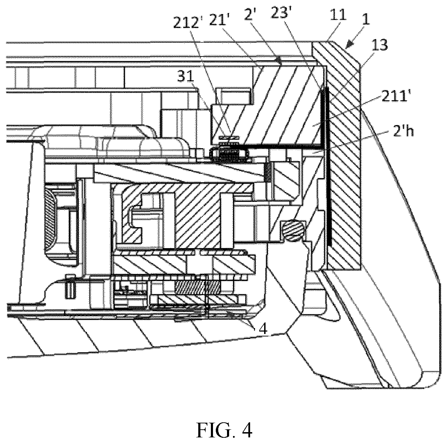

In this embodiment, in a process of extending from a first part 211' to a second part 212', a conductive part 23' does not extend through an outer surface (or an upper surface) of a plastic inner container 2'. As shown in FIG. 4, a through hole 2'h that penetrates through the plastic inner container 2' from a side on which a housing 1 is located to a side on which a circuit board assembly 3 is located is formed in the plastic inner container 2', and the conductive part 23' extends from the first part 211' to the second part 212' through the through hole 2'h. In this way, effect the same as that in the third embodiment can be achieved.

The following describes a structure of a wearable electronic device according to a fifth embodiment of this application.

### (Structure of the wearable electronic device according to the fifth embodiment of this application)

The structure of the wearable electronic device according to the fifth embodiment of this application is basically the same as the structure of the wearable electronic device according to the third embodiment of this application. The following mainly describes a difference between the two wearable electronic devices.

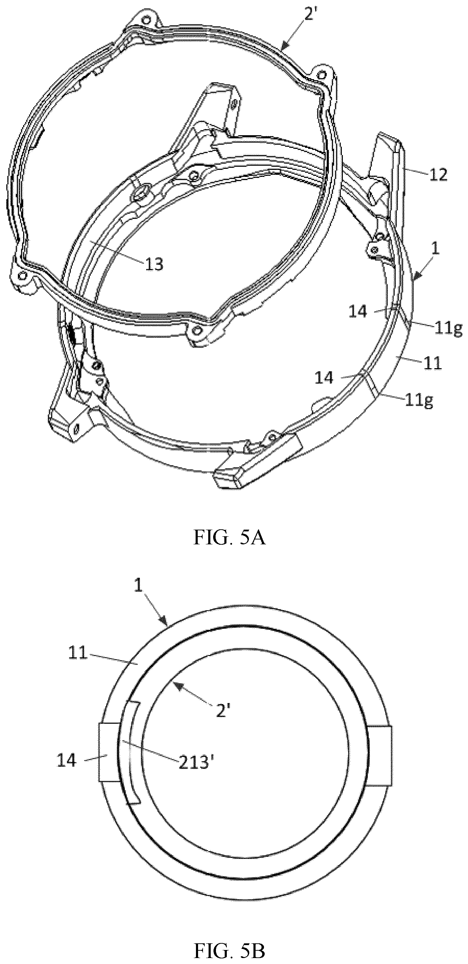

To improve antenna performance of a housing 1 mainly made of a carbon fiber, in this embodiment, as shown in FIG. 5A and FIG. 5B, a substrate 11 and a conductive layer 13 are disconnected in a circumferential direction of the substrate. A gap (slit) 11g is formed at a position at which the substrate 11 and the conductive layer 13 are disconnected. The housing 1 further includes a filling block 14 made of plastic. The filling block 14 is located in the gap 11g, and is fastened to the substrate 11. In this way, in a structural design in which the gap is disposed, parts obtained after segmentation of the housing 1 may be used as a Bluetooth antenna, a navigation satellite timing and ranging global position system (Navigation Satellite Timing and Ranging Global Position System, GPS for short) antenna, a Wi-Fi (Wireless Fidelity) antenna, and a 4th/5th mobile communication technology antenna (4G/5G communication antenna) with different bands. This can improve receiving and sending efficiency of an antenna signal.

Specifically, to implement the foregoing structure, the following manufacturing method may be used. First, a plurality of layers of carbon fibers are stacked and molded to form a semifinished part of the housing 1. Then, the corresponding gap 11g is obtained through mechanical processing, and the gap 11g is filled with plastic by using a molding process, to obtain an integrated semifinished part. Finally, a finished product of the housing 1 is manufactured through mechanical processing.

Alternatively, the following another manufacturing method may be used. First, a groove is cut at a regular position of carbon fiber prepreg (namely, carbon fiber cloth), a position of the groove is filled with plastic during hot pressing molding, and the carbon fiber and the plastic are molded to integrally form an embryo of the housing 1. Finally, a finished product of the housing 1 is obtained through mechanical processing. To further improve antenna performance, except that no conductive layer is disposed on an inner surface of the filling block 14, a conductive layer 13 is disposed on all remaining parts of an inner circumferential surface 111i of the substrate 11 of the housing 1.

In addition, in this embodiment, after a plastic inner container 2' is processed by using an injection molding process, the housing 1 and the plastic inner container 2' may be bonded together by using a bonding agent, to obtain a carbon fiber composite formed body in which the housing 1 and the plastic inner container 2' are integrated together. Similarly, the housing 1 including the filling block 14 may alternatively be used as an insert, and then the plastic inner container 2' is injection molded, to manufacture a carbon fiber composite formed body in which the housing 1 and the plastic inner container 2' are integrated together.

Further, as shown in FIG. 5B, to enhance bonding strength of the housing 1 at the gap 11g, a groove corresponding to the gap 11g on the housing 1 may be disposed in the plastic inner container 2', and a reinforcing block 213' may be mounted, and then assembly with plastic is performed by using an adhesive or a mechanical structure. In an optional solution, the carbon fiber prepreg (namely, the carbon fiber cloth) used for manufacturing the housing 1 is used to form a gap 11g at a regular position and is stacked. A wave-transparent and tough fiber material like a glass fiber is laid at a position of the gap 11g, and is crossed with the carbon fiber prepreg cloth, to improve interface strength. In this optional solution, the fibers may be arranged in a buckling manner, and a cross degree is increased to improve strength. In this way, the plastic inner container 2' cannot only be used for structural reinforcement and sealing, but also can provide antenna clearance.

In the technical solution, in this embodiment, not only effect the same as that in the fourth embodiment can be achieved, but also antenna performance of the housing 1 can be improved.

The following describes a structure of a wearable electronic device according to a sixth embodiment of this application.

### (Structure of the wearable electronic device according to the sixth embodiment of this application)

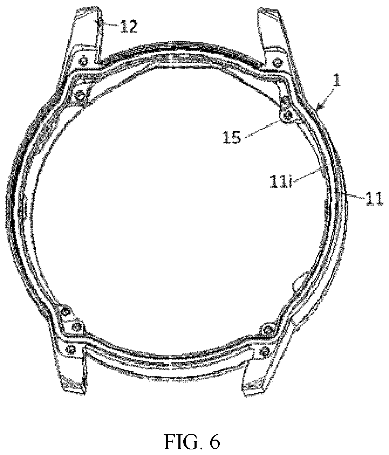

A difference from all the foregoing embodiments is that in this embodiment, the structure of the wearable electronic device includes a housing 1 shown in FIG. 6, and all inner container structures are omitted. A conductive layer is disposed on an inner circumferential surface 11i of a substrate of the housing 1. In this embodiment, a structure fastened to a circuit board assembly 3 is formed on the housing 1. The housing 1 is electrically connected to the circuit board assembly 3 without using an inner container.

In an optional solution, the wearable electronic device further includes a conductive adhesive. The conductive adhesive is located between the housing 1 and the circuit board assembly 3, and the housing 1 is electrically connected to the circuit board assembly 3 by using the conductive adhesive. In another optional solution, the wearable electronic device further includes a conductive fabric. The conductive fabric is located between the housing 1 and the circuit board assembly 3, and the housing 1 is electrically connected to the circuit board assembly 3 by using the conductive fabric. In still another optional solution, the wearable electronic device further includes an elastic component. The elastic component is located between the housing 1 and the circuit board assembly 3, the elastic component always applies elastic force to the housing 1 and the circuit board assembly 3, and the housing 1 is electrically connected to the circuit board assembly 3 by using the elastic component. In yet another optional solution, the housing 1 includes a protruding part 15 extending out to the circuit board assembly 3. The conductive layer is disposed on the protruding part 15, and the circuit board assembly 3 and the housing 1 are electrically connected by using the conductive layer on the protruding part 15. The first elastic component 24 or the second elastic component 31 described in the foregoing embodiments may be selected as the elastic component herein, or an elastic component with another structure may be selected.

Example embodiments of this application are described in the foregoing content. The following provides supplementary descriptions.
1. Although no clear descriptions are provided in the foregoing specific implementations, it should be understood that for different technical means in embodiments, provided that there is no conflict, these technical means may be combined to form various different technical solutions.
2. Although no clear descriptions are provided in the foregoing specific implementations, it should be understood that antenna performance can be optimized by controlling a length and an arrangement of the carbon fiber material.
3. Although no clear descriptions are provided in the foregoing specific implementations, it should be understood that for a composite formed structure of the housing 1 and the plastic inner container 2', after the housing 1 is put into an injection molding mold after being hot pressed, and then the plastic inner container 2' is injection molded, mechanical processing, polishing, and surface processing such as spraying a nanometer material, matte varnish, or gloss oil may be performed on the housing 1 based on a requirement; or an integrated structure of the molded housing 1 and the injection molded plastic inner container 2' may be completed by using an adhesive.
4. Although in the descriptions of the foregoing specific implementations, the housing 1 is mainly made of a carbon fiber material, it may be understood that at least one of a glass fiber, an aramid fiber, or an ultra-high molecular weight polyvinyl fiber may be further added to the housing 1. A fiber form may be a long fiber, a short fiber, or a combination thereof. In addition, a fiber arrangement manner may be a unidirectional manner, a bidirectional manner, a three-directional manner, a multi-directional manner, an out-of-order manner, and a combination of one, two, or more of the arrangement manners. The fiber is not limited to a color of raw silk. A surface may be formed in different colors through electroplating, spraying, dyeing, or other processing.
5. In the foregoing embodiments of this application, the wearable electronic device may include a watch bezel. The watch bezel may include a carbon fiber material, and the watch bezel is mounted and fastened to the housing 1. Therefore, the watch bezel and the housing 1 can be used as an antenna together, to further improve antenna performance of the wearable electronic device. The watch bezel may be further configured to cover an outer circumferential edge of the screen assembly 5, to protect the screen assembly 5. A scale used to mark a speed and the like may be disposed on the watch bezel, so that the wearable electronic device can implement an additional function like speed measurement. A decoration may be further disposed on the watch bezel, to improve appearance effect of the wearable electronic device.
6. In this application, it may be understood that the wearable electronic device may be an electronic device like a watch or a band that is worn on a wrist of a human body, or may be another electronic device that is worn on another part of a human body.

Although this application is described herein with reference to embodiments, in a process of implementing this application that claims protection, a person skilled in the art may understand and implement other variations to disclosed embodiments by viewing the accompanying drawings, disclosed content, and appended claims. In the claims, the word "comprise" does not exclude another component or step, and "a" or "one" does not exclude a case of plurality. Some measures are recorded in dependent claims that are different from each other, but this does not mean that these measures cannot be combined to produce better effect.

Embodiments of this application are described above. The foregoing descriptions are examples, are not exhaustive, and are not limited to disclosed embodiments. Many modifications and variations are clear to a person of ordinary skill in the art without departing from the scope of the invention, as defined by the appended claims. Selection of terms used in this specification is intended to best explain principles of embodiment, actual application, or improvements to technologies in the market, or to enable another person of ordinary skill in the art to understand embodiments disclosed in this specification.

## Claims

1. A wearable electronic device, wherein the wearable electronic device comprises a housing and a circuit board assembly, the circuit board assembly is located inside the housing, and is fastened relative to the housing, the housing comprises a carbon fiber material, the housing has an inner surface,
**characterised in that:**
the housing comprises a conductive layer disposed on the inner surface, the conductive layer electrically connects the carbon fiber material scattered in the housing, and the housing is electrically connected to the circuit board assembly by using the conductive layer.

2. The wearable electronic device according to claim 1, wherein the wearable electronic device further comprises a metal inner container, the metal inner container is located inside the housing, and the housing is electrically connected to the circuit board assembly by using the conductive layer and the metal inner container.

3. The wearable electronic device according to claim 2, wherein the wearable electronic device further comprises an elastic component, the elastic component is located between the housing and the metal inner container, and the housing is electrically connected to the metal inner container by using the elastic component.

4. The wearable electronic device according to claim 3, wherein the elastic component has a body and a spring plate, the body is fastened to one of the housing and the metal inner container, one end of the spring plate is connected to the body, and the other end of the spring plate is tilted relative to the body, to press against the other one of the housing and the metal inner container.

5. The wearable electronic device according to any one of claims 2 to 4, wherein the wearable electronic device further comprises a conductive adhesive or a conductive fabric, the conductive adhesive or the conductive fabric is located between the housing and the metal inner container, and the housing is electrically connected to the metal inner container by using the conductive adhesive or the conductive fabric.

6. The wearable electronic device according to any one of claims 2 to 5, wherein a part of the metal inner container is exposed from the housing.

7. The wearable electronic device according to claim 1, wherein the wearable electronic device further comprises a plastic inner container, the plastic inner container is located inside the housing, a conductive part is disposed in the plastic inner container, and the housing is electrically connected to the circuit board assembly by using the conductive part and the conductive layer.

8. The wearable electronic device according to claim 7, wherein the conductive part comprises a metal trace, and the metal trace is formed by using a laser direct structuring technology or through laser activating plating.

9. The wearable electronic device according to claim 7 or 8, wherein a through hole is formed in the plastic inner container, the through hole penetrates through the plastic inner container from a side on which the housing is located to a side on which the circuit board assembly is located, and the conductive part extends through the through hole.

10. The wearable electronic device according to any one of claims 7 to 9, wherein
the wearable electronic device further comprises a conductive adhesive, the conductive adhesive is located between the plastic inner container and the circuit board assembly, and the conductive part is electrically connected to the circuit board assembly by using the conductive adhesive;
the wearable electronic device further comprises a conductive fabric, the conductive fabric is located between the plastic inner container and the circuit board assembly, and the conductive part is electrically connected to the circuit board assembly by using the conductive fabric; or
the wearable electronic device further comprises an elastic component, the elastic component is located between the plastic inner container and the circuit board assembly, and the conductive part is electrically connected to the circuit board assembly by using the elastic component.

11. The wearable electronic device according to claim 10, wherein the elastic component has a body and a spring plate, the body is fastened to one of the plastic inner container and the circuit board assembly, one end of the spring plate is connected to the body, and the other end of the spring plate is tilted relative to the body, to press against the other one of the plastic inner container and the circuit board assembly.

12. The wearable electronic device according to claim 1, wherein the wearable electronic device further comprises a plastic inner container, the plastic inner container is located inside the housing, the housing comprises a protruding part, the protruding part passes through the plastic inner container and extends to the circuit board assembly, the conductive layer is further disposed on the protruding part, and the housing is electrically connected to the circuit board assembly by using the conductive layer on the protruding part.

13. The wearable electronic device according to any one of claims 2 to 12, wherein
the housing and the inner container are separately made, and the housing and the inner container are fastened to each other; or
the inner container and the housing are integrally formed.

14. The wearable electronic device according to any one of claims 1 to 13, wherein the housing comprises a ring-shaped substrate, the substrate comprises the carbon fiber material, the inner surface is an inner circumferential surface of the substrate, and the conductive layer continuously extends on the entire inner circumferential surface in a circumferential direction of the substrate.

15. The wearable electronic device according to any one of claims 1 to 13, wherein the housing comprises a substrate and a filling block, a slit is formed in the substrate, the slit is filled with the filling block, so that the substrate and the filling block form a ring shape together, and the inner surface is an inner circumferential surface of the substrate and an inner circumferential surface of the filling block.

## Patentansprüche

1. Tragbare elektronische Vorrichtung, wobei die tragbare elektronische Vorrichtung ein Gehäuse und eine Leiterplattenbaugruppe umfasst, die Leiterplattenbaugruppe sich innerhalb des Gehäuses befindet und relativ zum Gehäuse befestigt ist, das Gehäuse ein Kohlefasermaterial umfasst und das Gehäuse eine Innenfläche aufweist, **dadurch gekennzeichnet, dass**:
das Gehäuse eine auf der Innenfläche angeordnete leitfähige Schicht umfasst, die leitfähige Schicht verbindet das im Gehäuse verstreute Kohlefasermaterial elektrisch, und das Gehäuse unter Verwendung der leitfähigen Schicht elektrisch mit der Leiterplattenbaugruppe verbunden ist.

2. Tragbare elektronische Vorrichtung nach Anspruch 1, wobei die tragbare elektronische Vorrichtung ferner einen Metall-Innenbehälter umfasst, der Metall-Innenbehälter sich im Inneren des Gehäuses befindet und das Gehäuse unter Verwendung der leitenden Schicht und des Metall-Innenbehälters elektrisch mit der Leiterplattenbaugruppe verbunden ist.

3. Tragbare elektronische Vorrichtung nach Anspruch 2, wobei die tragbare elektronische Vorrichtung ferner eine elastische Komponente umfasst, die elastische Komponente sich zwischen dem Gehäuse und dem Metall-Innenbehälter befindet und das Gehäuse unter Verwendung der elastischen Komponente elektrisch mit dem Metall-Innenbehälter verbunden ist.

4. Tragbare elektronische Vorrichtung nach Anspruch 3, wobei die elastische Komponente einen Körper und eine Federplatte aufweist, der Körper entweder am Gehäuse oder am Metall-Innenbehälter befestigt ist, ein Ende der Federplatte mit dem Körper verbunden ist und das andere Ende der Federplatte relativ zum Körper geneigt ist, um gegen den anderen Teil des Gehäuses oder des Metall-Innenbehälters zu drücken.

5. Tragbare elektronische Vorrichtung nach einem der Patentansprüche 2 bis 4, wobei die tragbare elektronische Vorrichtung ferner einen leitfähigen Klebstoff oder ein leitfähiges Gewebe umfasst, der leitfähige Klebstoff oder das leitfähige Gewebe sich zwischen dem Gehäuse und dem Metall-Innenbehälter befindet und das Gehäuse unter Verwendung des leitfähigen Klebstoffs oder des leitfähigen Gewebes elektrisch mit dem Metall-Innenbehälter verbunden ist.

6. Tragbare elektronische Vorrichtung nach einem der Patentansprüche 2 bis 5, wobei ein Teil des Metall-Innenbehälters gegenüber dem Gehäuse freiliegt.

7. Tragbare elektronische Vorrichtung nach Anspruch 1, wobei die tragbare elektronische Vorrichtung ferner einen Kunststoff-Innenbehälter umfasst, der Kunststoff-Innenbehälter sich innerhalb des Gehäuses befindet, ein leitfähiges Teil im Kunststoff-Innenbehälter angeordnet ist und das Gehäuse unter Verwendung des leitfähigen Teils und der leitfähigen Schicht elektrisch mit der Leiterplattenbaugruppe verbunden ist.

8. Tragbare elektronische Vorrichtung nach Anspruch 7, wobei der leitfähige Teil eine Metallspur umfasst und die Metallspur unter Verwendung einer Laser-Direktstrukturierungstechnologie oder durch Laseraktivierungsbeschichtung gebildet wird.

9. Tragbare elektronische Vorrichtung nach Anspruch 7 oder 8, wobei ein Durchgangsloch in dem Kunststoff-Innenbehälter gebildet ist, das Durchgangsloch den Kunststoff-Innenbehälter von einer Seite, auf der sich das Gehäuse befindet, zu einer Seite durchdringt, auf der sich die Leiterplattenbaugruppe befindet, und der leitfähige Teil sich durch das Durchgangsloch erstreckt.

10. Tragbare elektronische Vorrichtung nach einem der Patentansprüche 7 bis 9, wobei
die tragbare elektronische Vorrichtung ferner einen leitfähigen Klebstoff umfasst, der leitfähige Klebstoff sich zwischen dem Kunststoff-Innenbehälter und der Leiterplattenbaugruppe befindet und das leitfähige Teil unter Verwendung des leitfähigen Klebstoffs elektrisch mit der Leiterplattenbaugruppe verbunden ist;
die tragbare elektronische Vorrichtung ferner ein leitfähiges Gewebe umfasst, das leitfähige Gewebe sich zwischen dem Kunststoff-Innenbehälter und der Leiterplattenbaugruppe befindet und das leitfähige Teil unter Verwendung des leitfähigen Gewebes elektrisch mit der Leiterplattenbaugruppe verbunden ist; oder
die tragbare elektronische Vorrichtung ferner eine elastische Komponente umfasst, die elastische Komponente sich zwischen dem Kunststoff-Innenbehälter und der Leiterplattenbaugruppe befindet und der leitfähige Teil unter Verwendung der elastischen Komponente elektrisch mit der Leiterplattenbaugruppe verbunden ist.

11. Tragbare elektronische Vorrichtung nach Anspruch 10, wobei die elastische Komponente einen Körper und eine Federplatte aufweist, der Körper entweder an dem Kunststoff-Innenbehälter oder an der Leiterplattenbaugruppe befestigt ist, ein Ende der Federplatte mit dem Körper verbunden ist und das andere Ende der Federplatte relativ zum Körper geneigt ist, um gegen den anderen Kunststoff-Innenbehälter oder die Leiterplattenbaugruppe zu drücken.

12. Tragbare elektronische Vorrichtung nach Anspruch 1, wobei die tragbare elektronische Vorrichtung ferner einen Kunststoff-Innenbehälter umfasst, der Kunststoff-Innenbehälter sich innerhalb des Gehäuses befindet, das Gehäuse einen vorstehenden Teil umfasst, der vorstehende Teil durch den Kunststoff-Innenbehälter hindurchgeht und sich zu der Leiterplattenbaugruppe erstreckt, die leitfähige Schicht ferner auf dem vorstehenden Teil angeordnet ist und das Gehäuse unter Verwendung der leitfähigen Schicht auf dem vorstehenden Teil elektrisch mit der Leiterplattenbaugruppe verbunden ist.

13. Tragbare elektronische Vorrichtung nach einem der Patentansprüche 2 bis 12, wobei
das Gehäuse und der Innenbehälter separat hergestellt sind und das Gehäuse und der Innenbehälter aneinander befestigt sind; oder
der Innenbehälter und das Gehäuse sind einstückig ausgebildet.

14. Tragbare elektronische Vorrichtung nach einem der Patentansprüche 1 bis 13, wobei das Gehäuse ein ringförmiges Substrat umfasst, das Substrat das Kohlefasermaterial umfasst, die Innenfläche eine Innenumfangsfläche des Substrats ist und die leitfähige Schicht sich kontinuierlich auf der gesamten Innenumfangsfläche in einer Umfangsrichtung des Substrats erstreckt.

15. Tragbare elektronische Vorrichtung nach einem der Patentansprüche 1 bis 13, wobei das Gehäuse ein Substrat und einen Füllblock umfasst, ein Schlitz im Substrat ausgebildet ist, der Schlitz mit dem Füllblock gefüllt ist, so dass das Substrat und der Füllblock zusammen eine Ringform bilden, und die Innenfläche eine Innenumfangsfläche des Substrats und eine Innenumfangsfläche des Füllblocks ist.

## Revendications

1. Dispositif électronique pouvant être porté, dans lequel le dispositif électronique pouvant être porté comprend un boîtier et un ensemble de cartes de circuit imprimé, l'ensemble de cartes de circuit imprimé est situé à l'intérieur du boîtier, et est fixé par rapport au boîtier, le boîtier comprend un matériau en fibre de carbone, le boîtier a une surface intérieure, **caractérisé en ce que** :
le boîtier comprend une couche conductrice disposée sur la surface intérieure, la couche conductrice connecte électriquement le matériau en fibre de carbone dispersé dans le boîtier, et le boîtier est connecté électriquement à l'ensemble de cartes de circuit imprimé à l'aide la couche conductrice.

2. Dispositif électronique pouvant être porté selon la revendication 1, dans lequel le dispositif électronique pouvant être porté comprend également un récipient intérieur métallique, le récipient intérieur métallique est situé à l'intérieur du boîtier, et le boîtier est connecté électriquement à l'ensemble de cartes de circuit imprimé à l'aide de la couche conductrice et du récipient intérieur métallique.

3. Dispositif électronique pouvant être porté selon la revendication 2, dans lequel le dispositif électronique pouvant être porté comprend également un composant élastique, le composant élastique est situé entre le boîtier et le récipient intérieur métallique, et le boîtier est connecté électriquement au récipient intérieur métallique à l'aide du composant élastique.

4. Dispositif électronique pouvant être porté selon la revendication 3, dans lequel le composant élastique a un corps et une plaque à ressort, le corps est fixé à l'un du boîtier et du récipient intérieur métallique, une extrémité de la plaque à ressort est connectée au corps, et l'autre extrémité de la plaque à ressort est inclinée par rapport au corps, pour appuyer contre l'autre du boîtier et du récipient intérieur métallique.

5. Dispositif électronique pouvant être porté selon l'une quelconque des revendications 2 à 4, dans lequel le dispositif électronique pouvant être porté comprend également un adhésif conducteur ou un tissu conducteur, l'adhésif conducteur ou le tissu conducteur est situé entre le boîtier et le récipient intérieur métallique, et le boîtier est connecté électriquement au récipient intérieur métallique à l'aide de l'adhésif conducteur ou du tissu conducteur.

6. Dispositif électronique pouvant être porté selon l'une quelconque des revendications 2 à 5, dans lequel une partie du récipient intérieur métallique est exposée à partir du boîtier.

7. Dispositif électronique pouvant être porté selon la revendication 1, dans lequel le dispositif électronique pouvant être porté comprend également un récipient intérieur en plastique, le récipient intérieur en plastique est situé à l'intérieur du boîtier, une partie conductrice est disposée dans le récipient intérieur en plastique, et le boîtier est connecté électriquement à l'ensemble de cartes de circuit imprimé à l'aide de la partie conductrice et de la couche conductrice.

8. Dispositif électronique pouvant être porté selon la revendication 7, dans lequel la partie conductrice comprend une trace métallique, et la trace métallique est formée à l'aide d'une technologie de structuration directe par laser ou par placage par activation laser.

9. Dispositif électronique pouvant être porté selon la revendication 7 ou 8, dans lequel un trou traversant est formé dans le récipient intérieur en plastique, le trou traversant pénètre à travers le récipient intérieur en plastique d'un côté sur lequel le boîtier est situé à un côté sur lequel l'ensemble de cartes de circuit imprimé est situé, et la partie conductrice se prolonge à travers le trou traversant.

10. Dispositif électronique pouvant être porté selon l'une quelconque des revendications 7 à 9, dans lequel
le dispositif électronique pouvant être porté comprend également un adhésif conducteur, l'adhésif conducteur est situé entre le récipient intérieur en plastique et l'ensemble de cartes de circuit imprimé, et la partie conductrice est connectée électriquement à l'ensemble de cartes de circuit imprimé à l'aide de l'adhésif conducteur ;
le dispositif électronique pouvant être porté comprend également un tissu conducteur, le tissu conducteur est situé entre le récipient intérieur en plastique et l'ensemble de cartes de circuit imprimé, et la partie conductrice est connectée électriquement à l'ensemble de cartes de circuit imprimé à l'aide du tissu conducteur ; ou
le dispositif électronique pouvant être porté comprend également un composant élastique, le composant élastique est situé entre le récipient intérieur en plastique et l'ensemble de cartes de circuit imprimé, et la partie conductrice est connectée électriquement à l'ensemble de cartes de circuit imprimé à l'aide du composant élastique.

11. Dispositif électronique pouvant être porté selon la revendication 10, dans lequel le composant élastique a un corps et une plaque à ressort, le corps est fixé à l'un du récipient intérieur en plastique et de l'ensemble de cartes de circuit imprimé, une extrémité de la plaque à ressort est connectée au corps, et l'autre extrémité de la plaque à ressort est inclinée par rapport au corps, pour appuyer contre l'autre du boîtier et du récipient intérieur métallique.

12. Dispositif électronique pouvant être porté selon la revendication 1, dans lequel le dispositif électronique pouvant être porté comprend également un récipient intérieur en plastique, le récipient intérieur en plastique est situé à l'intérieur du boîtier, le boîtier comprend une partie saillante, la partie saillante traverse le récipient intérieur en plastique et se prolonge jusqu'à l'ensemble de cartes de circuit imprimé, la couche conductrice est également disposée sur la partie saillante, et le boîtier est connecté électriquement à l'ensemble de cartes de circuit imprimé à l'aide de la couche conductrice sur la partie saillante.

13. Dispositif électronique pouvant être porté selon l'une quelconque des revendications 2 à 12, dans lequel
le boîtier et le récipient intérieur sont fabriqués séparément, et le boîtier et le récipient intérieur sont fixés l'un à l'autre ; ou
le récipient intérieur et le boîtier sont formés d'un seul tenant.

14. Dispositif électronique pouvant être porté selon l'une quelconque des revendications 1 à 13, dans lequel le boîtier comprend un substrat en forme d'anneau, le substrat comprend le matériau en fibre de carbone, la surface intérieure est une surface circonférentielle intérieure du substrat, et la couche conductrice se prolonge en continu sur toute la surface circonférentielle intérieure dans une direction circonférentielle du substrat.

15. Dispositif électronique pouvant être porté selon l'une quelconque des revendications 1 à 13, dans lequel le boîtier comprend un substrat et un bloc de remplissage, une fente est formée dans le substrat, la fente est remplie avec le bloc de remplissage, de sorte que le substrat et le bloc de remplissage forment ensemble une forme d'anneau, et la surface intérieure est une surface circonférentielle intérieure du substrat et une surface circonférentielle intérieure du bloc de remplissage.
